# EUROPEAN PATENT APPLICATION

(11) **EP 4 329 437 A1**
(43) Date of publication of application: **28.02.2024**
(21) Application number: 22833518.8
(22) Date of filing: 24.06.2022
(51) Int. Cl.: H05K 1/09, H05K 3/00, H05K 3/18, C23C 28/02, C23C 18/40

(54) **METAL FOIL WITH CARRIER FOIL, LAMINATE FOR PRINTED WIRING BOARD USING SAME, AND MANUFACTURING METHOD FOR LAMINATE**

(30) Priority: 02.07.2021 KR 20210086969
(71) Applicant: YMT Co., Ltd., Incheon 21690 (KR)
(72) Inventor: CHUN, Sung Wook, Incheon 21996 (KR); CHUNG, Bo Mook, Incheon 21986 (KR); PARK, Myong Whan, Incheon 21613 (KR)
(74) Representative: Prüfer & Partner mbB Patentanwälte · Rechtsanwälte
(86) International application number: PCT/KR2022/009044
(87) International publication number: WO 2023/277462

(57) **Abstract**

The present invention relates to a carrier foil-attached metal foil, a laminate for a printed wiring board manufactured using the carrier foil-attached metal foil, and a manufacturing method of the laminate for the printed wiring board.

## Description

### CROSS-REFERENCE TO RELATED APPLICATION

This application claims under 35 U.S.C. §119(a) the benefit of Korean Patent Application No. 10-2021-0086969 filed on 07.02, 2021, 2021, the entire contents of which are incorporated herein by reference.

### BACKGROUND

### (a) Technical Field

The present invention relates to a carrier foil-attached metal foil, a laminate for a printed wiring board using the carrier foil-attached metal foil, and a manufacturing method of the laminate for the printed wiring board.

### (b) Background Art

With the high integration of various electronic components, a printed wiring board having a high-density ultra-fine wiring pattern is required. The printed wiring board may be manufactured by forming a high-density ultra-fine wiring pattern on a metal foil included in the printed wiring board.

However, when the metal foil included in the printed wiring board is thick, since an etching time is long when forming the wiring pattern, and thus the verticality of a side wall of the formed wiring pattern is collapsed, there may be a problem that causes a disconnection. Accordingly, a relatively thin metal foil has been mainly used for manufacturing the printed wiring board having the high-density ultra-fine wiring pattern.

Here, since the thin metal foil has a weak mechanical strength and thus may be easily wrinkled or bent during the manufacturing of the printed wiring board, to compensate for this problem, a carrier foil-attached metal foil in which a carrier foil is attached to one surface of the metal foil through a release layer is used. Specifically, after the carrier foil-attached metal foil is bonded with a resin substrate, a basic structure of the printed wiring board is formed by peeling the release layer bonded with the carrier foil from the carrier foil-attached metal foil.

In order to secure the peelability of the release layer bonded with the carrier foil, most of the carrier foil-attached metal foils are manufactured so that the release layer to which the carrier foil is bonded can be peeled off from the carrier foil-attached metal foil even if a predetermined force is applied before bonding to the resin substrate.

However, if manufactured as such, there is a problem in that it is not easy to handle the carrier foil-attached metal foil and a defective printed wiring board is manufactured. In other words, since the carrier foil-attached metal foil needs to be careful when moved so that peeling does not occur, it is not easy to handle it. In addition, in the process of bonding the carrier foil-attached metal foil and the resin substrate, undesired peeling occurs, and thus the metal foil is damaged, and thereby the defective printed wiring board is manufactured.

Therefore, there is a demand for the development of a carrier foil-attached metal foil with improved peelability so that peeling can be performed at a desired time point.

### [Prior Arts]

### [Patent Documents]

(Patent Document 1) Korean Patent Publication No. 2013-0082320

### SUMMARY OF THE DISCLOSURE

An object of the present invention is to provide a carrier foil-attached metal foil with controlled peelability so that peeling can be performed at a desired time point.

Another object of the present invention is to provide a laminate for a printed wiring board including the carrier foil-attached metal foil structure.

Yet another object of the present invention is to provide a manufacturing method of the laminate for the printed wiring board.

According to an aspect of the present invention, there is provided a carrier foil-attached metal foil including: a carrier foil; a release layer provided on the carrier foil and comprising at least one selected from the group consisting of titanium, copper, nickel and aluminum; and a metal layer provided on the release layer and formed by electroless plating.

The thickness of the release layer may be 1 nm to 100 nm.

The metal layer may be a porous metal layer.

The porosity of the metal layer may be 5% to 40%.

According to another aspect of the present invention, there is provided a laminate for a printed wiring board including: a carrier foil; a release layer provided on the carrier foil and comprising at least one selected from the group consisting of titanium, copper, nickel and aluminum; a metal layer provided on the release layer and formed by electroless plating; and a resin layer provided on the metal layer.

The laminate for the printed wiring board may further include an oxide release layer provided between the release layer and the metal layer.

According to yet another aspect of the present invention, there is provided a manufacturing method of a laminate for a printed wiring board including the steps of:
preparing a carrier foil; forming a release layer comprising at least one selected from the group consisting of titanium, copper, nickel and aluminum on the carrier foil; forming a metal layer on the release layer by electroless plating; and forming a resin layer by laminating a resin substrate on the metal layer.

The manufacturing method of the laminate for the printed wiring board according to the present invention may further include a step of forming an oxide release layer between the release layer and the metal layer by pressing at 10 MPa to 40 MPa and 180°C to 220°C.

In the carrier foil-attached metal foil according to the present invention, the release layer to which the carrier foil is bonded is not peeled off from the carrier foil-attached metal foil before bonding with the resin substrate, but after bonding with the resin substrate, the release layer to which the carrier foil is bonded is peeled off from the carrier foil-attached metal foil, thereby easily handling the carrier foil-attached metal foil and minimizing the manufacture of a defective printed wiring board.

### BRIEF DESCRIPTION OF THE DRAWINGS

FIG. 1 is a schematic view showing a carrier foil-attached metal foil according to an embodiment of the present invention.
FIG. 2 is a schematic view showing a laminate for a printed wiring board according to an embodiment of the present invention.

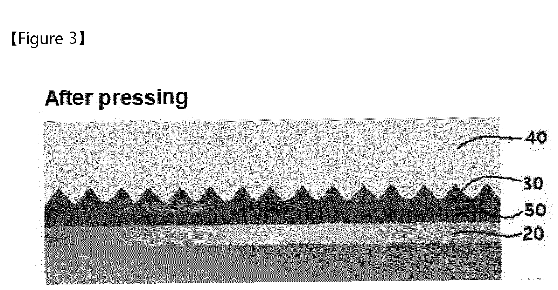

FIG. 3 is a schematic view showing a laminate for a printed wiring board according to another embodiment of the present invention.

### DETAILED DESCRIPTION

The terms and words used in the specification and claims of the present invention should not be construed as limited to ordinary or dictionary meanings, and should be construed in a sense and concept consistent with the technical idea of the present invention, based on the principle that the inventor can properly define the concept of a term to describe his/her own invention in the best way possible.

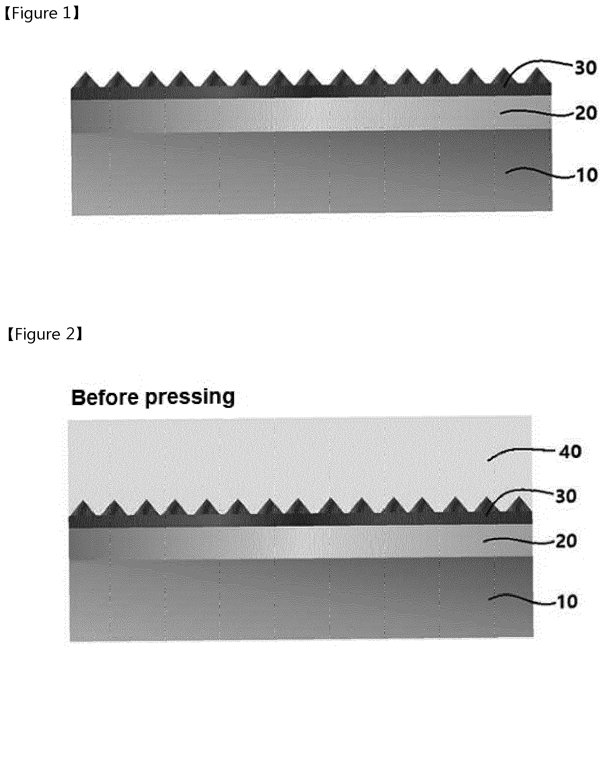

The present invention relates to a carrier foil-attached metal foil with controlled peelability so that peeling can be performed at a desired time point, a laminate for a printed wiring board including the carrier foil-attached metal foil structure, and a manufacturing method thereof. Specifically, in the carrier foil-attached metal foil according to the present invention, peeling does not occur before bonding with a resin substrate, but peeling occurs after bonding with the resin substrate, which will be described with reference to FIG. 1 as follows.

The carrier foil-attached metal foil according to the present invention includes a carrier foil 10, a release layer 20, and a metal layer 30.

The carrier foil 10 included in the carrier foil-attached metal foil according to the present invention may serve as a support layer to prevent the metal layer 30 from being deformed in the process of moving or using the carrier foil-attached metal foil. Such a carrier foil 10 may be made of a metal such as copper or aluminum; or a polymer such as polyethylene terephthalate (PET), polyphenylene sulfide (PPS), or Teflon.

The thickness of the carrier foil 10 may be 10 to 50 µm, specifically 15 to 40 µm. If the thickness of the carrier foil 10 is within the above range, it is possible to prevent the carrier foil-attached metal foil from being thicker than necessary while smoothly serving as a support layer.

The release layer 20 included in the carrier foil-attached metal foil according to the present invention is provided on the carrier foil 10, and may serve as a release layer that allows the carrier foil 10 to be peeled off. The release layer 20 may include one or more metals selected from the group consisting of titanium (Ti), copper, nickel, and aluminum. If the release layer 20 includes one or more metals described above, a strong bond with the metal layer 30 is formed, so that the peeling between the release layer 20 and the metal layer 30 does not occur in the carrier foil-attached metal foil itself, but the peeling between the release layer 20 and the metal layer 30 may occur after a process of bonding with the resin substrate at high temperature and pressure is performed to manufacture the laminate for the printed wiring board. In particular, the release layer 20 may be made of titanium. If the release layer 20 is made of titanium, the release layer 20 may be peeled off from the carrier foil-attached metal foil at a more desired time point.

The thickness of the release layer 20 may be 1 to 100 nm, specifically 30 to 80 nm. If the release layer 20 has the thickness within the above range, it may exhibit a required bonding force with the metal layer 30, and may be peeled off at a desired time point.

The metal layer 30 included in the carrier foil-attached metal foil according to the present invention is provided on the release layer 20, and may serve as a circuit layer through a process of forming a wiring pattern during the manufacturing process of the printed wiring board. The metal layer 30 may be made of at least one selected from the group consisting of copper and nickel.

If the metal layer 30 is formed by electroless plating, it may have porosity due to this. That is, the metal layer 30 according to the present invention is formed by electroless plating rather than electrolytic plating, so it may be a porous metal layer. If the metal layer 30 is a porous metal layer, to manufacture the laminate for the printed wiring board, the peeling between the release layer 20 and the metal layer 30 may occur after the process of bonding with the resin substrate is performed at high temperature and pressure, which will be described hereinafter in detail.

Here, if the metal layer 30 is a porous metal layer, its porosity may be 5 to 40%, specifically, 10 to 30%. The porosity may mean a volume ratio occupied by pores in the total volume of the metal layer 30. If the metal layer 30 has the porosity within the above range, it may control the release layer 20 to be peeled off at a desired time point, and may also smoothly serve as the circuit layer thereafter.

In addition, considering the peelability as well as the role of the circuit layer, the thickness of the metal layer 30 may be 0.5 to 5 µm, specifically, 1 to 3 µm.

Meanwhile, as shown in FIG. 1, a plurality of cone-shaped or polypyramid-shaped protrusion may be formed on the surface of the metal layer 30. The protrusion may be formed by the growth of metal crystals in the process of forming the metal layer 30 by electroless plating. Due to this protrusion, the metal layer 30 may have a surface roughness Ra of 0.05 to 0.4 µm, specifically 0.1 to 0.3 µm. As such, if the plurality of cone-shaped or polypyramid-shaped protrusion is formed on the metal layer 30, the metal layer 30 may exhibit high bonding strength with the resin substrate during the manufacturing process of the laminate for the printed wiring board.

In the carrier foil-attached metal foil according to the present invention, the release layer 20 including at least one metal selected from the group consisting of titanium, copper, nickel and aluminum exhibits high bonding strength with the metal layer 30, so that the carrier foil 10 through the release layer 20 is not peeled off in the carrier foil-attached metal foil itself even if a predetermined force is applied, thereby easily handling the carrier foil-attached metal foil.

In addition, when the carrier foil-attached metal foil according to the present invention is laminated with the resin substrate at high temperature and pressure during the manufacturing process of the laminate for the printed wiring board by the metal layer 30 formed by electroless plating, an oxide release layer is formed between the release layer 20 and the metal layer 30, so that the carrier foil 10 may be peeled off well, which will be described in more detail in the description of the laminate for the printed wiring board to be described hereinafter.

The present invention provides a laminate for a printed wiring board including the carrier foil-attached metal foil structure described above. Specifically, referring to FIG. 2, the laminate for the printed wiring board according to the present invention includes a carrier foil 10, a release layer 20, a metal layer 30, and a resin layer 40.

The description of the carrier foil 10, the release layer 20 and the metal layer 30 included in the laminate for the printed wiring board according to the present invention is the same as those described in the carrier foil-attached metal foil, so the detailed description thereof will be omitted. That is, the laminate for the printed wiring board according to the present invention may be one in which the resin layer 40 is provided on the carrier foil-attached metal foil including the carrier foil 10, the release layer 20 and the metal layer 30.

The resin layer 40 included in the laminate for the printed wiring board according to the present invention is provided on the metal layer 30 described above, and may serve as an insulating layer. The resin layer may be formed of a resin substrate (e.g., prepreg) having a structure in which inorganic or organic fibers are impregnated with resin. The resin may be at least one selected from the group consisting of naphthalene-based epoxy resin, bisphenol A-type epoxy resin, phenol novolac epoxy resin, cresol novolac epoxy resin, rubber-modified epoxy resin, phosphorus-based epoxy resin, bisphenol F-type epoxy resin, and polyimide resin.

The laminate for the printed wiring board according to the present invention may further include an oxide release layer 50 provided between the release layer 20 and the metal layer 30. The oxide release layer 50 is formed by oxidizing a part of the release layer 20 (specifically, the surface of the release layer 20 in contact with the metal layer 30), and by this oxide release layer 50, the carrier foil 10 may be smoothly peeled off (that is, the peeling of the oxide release layer 50 bonded with the carrier foil 10 and the release layer 20) while preventing components of the release layer 20 from remaining in the metal layer 30.

The oxide release layer 50 may be made of at least one metal oxide selected from the group consisting of titanium oxide, copper oxide, nickel oxide, and aluminum oxide.

The oxide release layer 50 may be naturally formed in the process of forming the resin layer 40 by bonding with the resin substrate rather than passing through the process of additionally forming the oxide release layer 50 during the manufacturing process of the laminate for the printed wiring board. That is, according to the present invention, the oxide release layer 50 may be formed naturally even without passing through an artificial oxidation process when manufacturing the laminate for the printed wiring board, which will be described in detail in the following method for manufacturing the laminate for the printed wiring board.

The present invention provides the manufacturing method of the laminate for the printed wiring board described above. Specifically, the manufacturing method of the laminate for the printed wiring board includes the steps of: preparing a carrier foil; forming a release layer including at least one selected from the group consisting of titanium, copper, nickel and aluminum on the carrier foil; forming a metal layer on the release layer by electroless plating; and laminating a resin substrate on the metal layer to form a resin layer.

The step of preparing of the carrier foil may be performed by preparing a metal thin film made of copper or aluminum; or a polymer thin film made of polyethylene terephthalate (PET), polyphenylene sulfide (PPS), or Teflon.

The step of forming the release layer may be performed by forming the release layer including at least one selected from the group consisting of titanium, copper, nickel and aluminum on the prepared carrier foil. As the method of forming the release layer, sputtering, etc. may be included.

The step of forming of the metal layer may be performed on the release layer formed by electroless plating. For the electroless plating, an electroless plating solution including a metal ion source and a nitrogen-containing compound may be used.

The metal ion source may be specifically at least one selected from the group consisting of copper sulfate, copper chloride, copper nitrate, copper hydroxide, and copper sulfamate. The concentration of the metal ion source may be 0.5 to 300 g/L, specifically 100 to 200 g/L.

The nitrogen-containing compound diffuses metal ions to form a plurality of protrusions on the surface of a metal seed layer formed by the metal ion source. The nitrogen-containing compound may be specifically at least one selected from the group consisting of purine, adenine, guanine, hypoxanthine, xanthine, pyridazine, methylpiperidine, 1,2-di-(2-pyridyl)ethylene, 1,2-di-(pyridyl)ethylene, 2,2'-dipyridylamine, 2,2'-bipyridyl, 2,2'-bipyrimidine, 6,6'-dimethyl-2,2'-dipyridyl, di-2-pyrylketone, N,N,N',N'-tetraethylenediamine, 1,8-naphthyridine, 1,6-naphthyridine, and terpyridine. The concentration of the nitrogen-containing compound may be 0.01 to 10 g/L, specifically 0.05 to 1 g/L.

The electroless plating solution may further include at least one additive selected from the group consisting of a chelating agent, a pH adjusting agent, and a reducing agent.

The chelating agent may be specifically at least one selected from the group consisting of tartaric acid, citric acid, acetic acid, malic acid, malonic acid, ascorbic acid, oxalic acid, lactic acid, succinic acid, potassium sodium tartrate, dipotassium tartrate, hydantoin, 1-methylhydantoin, 1,3-dimethylhydantoin, 5,5-dimethylhydantoin, nitriloacetic acid, triethanolamine, ethylenediaminetetraacetic acid, tetrasodiumethylenediaminetetraacetate, N-hydroxyethylenediaminetriacetate and pentahydroxypropyldiethylenetriamine. The concentration of the chelating agent may be 0.5 to 600 g/L, specifically 300 to 450 g/L.

The pH adjusting agent may be specifically at least one selected from the group consisting of sodium hydroxide, potassium hydroxide and lithium hydroxide. The pH adjusting agent may be included in an electroless plating solution such that the pH of the electroless plating solution is adjusted to 8 or more, specifically 10 to 14, and more specifically 11 to 13.5.

The reducing agent may be specifically at least one selected from the group consisting of formaldehyde, sodium hypophosphite, sodium hydroxymethane sulfinate, glyoxylic acid, borohydride, and dimethylamine borane. The concentration of the reducing agent may be 1 to 20 g/L, specifically 5 to 20 g/L.

Plating conditions for forming the metal layer by electroless plating with the electroless plating solution may be appropriately adjusted according to the thickness of the metal layer. Specifically, the electroless plating temperature may be 20 to 60°C, specifically 30 to 40°C, and the electroless plating time may be 2 to 30 minutes, specifically 5 to 20 minutes.

By performing electroless plating with such an electroless plating solution to form a metal layer, the present invention may form a porous metal layer.

The step of forming the resin layer may include laminating a resin substrate on the formed metal layer. As the resin substrate, a resin substrate having a structure in which the aforementioned inorganic or organic fibers are impregnated with a resin may be used.

Meanwhile, the manufacturing method of the laminate for the printed wiring board according to the present invention may further include the step of forming an oxide release layer between the release layer and the metal layer. Specifically, the oxide release layer may be formed between the release layer and the metal layer by pressing the laminate in which the carrier foil, the release layer, the metal layer, and the resin layer are laminated under high temperature and pressure conditions.

That is, the resin substrate is laminated on the metal layer, and then to bond the resin layer and the metal layer, the laminated resin substrate passes through a pressing process under high temperature and pressure conditions, but in the present invention, an oxide release layer may be naturally formed between the release layer and the metal layer during the pressing process. In the present invention, the metal layer has porosity, so that oxygen moves to the release layer through the pores of the metal layer during the pressing process under high temperature and pressure, thereby oxidizing the release layer.

The high temperature and pressure press may be performed at 10 to 40 MPa (specifically 15 to 30 MPa) and at 180 to 220°C (specifically 190 to 210°C).

As such, the present invention has a feature of naturally forming the oxide release layer by the porous metal layer in the process of laminating the resin substrate on the carrier foil-attached metal foil structure rather than passing through the process of artificially oxidizing the carrier foil-attached metal foil itself or the laminate to which the resin substrate is bonded during the manufacturing process of the laminate for the printed wiring board and due to this, the carrier foil is not peeled off in the carrier foil-attached metal foil itself according to the present invention, but may be peeled off in the laminate for the printed wiring board that is bonded with the resin substrate by the oxide release layer. Accordingly, the present invention may provide a laminate for a printed wiring board with excellent reliability by minimizing a defect occurrence rate.

The present invention provides a printed circuit board manufactured using the laminate for the printed wiring board described above. Specifically, the printed circuit board according to the present invention includes a metal circuit layer and a resin layer, and the metal circuit layer is originated from the metal layer described above, which will be described as follows.

The metal circuit layer included in the printed circuit board according to the present invention is a layer on which a circuit wiring is formed. Such a metal circuit layer is obtained through the process of forming a circuit wiring on the metal layer described above. The method of forming the circuit wiring is not particularly limited, and may be a subtractive process, an additive process, a full additive process, a semi additive process, or a modified semi additive process.

The resin layer included in the printed circuit board according to the present invention is an insulating layer provided on the metal circuit layer. Such a resin layer may be made of a commonly known resin substrate. Specifically, the resin layer may be formed of a resin substrate (e.g., prepreg) having a structure in which inorganic or organic fibers are impregnated with a commonly known resin.

The printed circuit board according to the present invention may be manufactured using a resin substrate or may be manufactured by a coreless method in which the resin substrate is excluded.

Hereinafter, the present invention will be described in more detail with reference to the Examples. However, the following Examples are intended to illustrate the present invention, and it will be apparent to those skilled in the art that various changes and modifications can be made within the scope and spirit of the present invention, and the scope of the present invention is not limited thereto.

### [Example 1]

A carrier foil made of 18 µm-thick copper foil was immersed in sulfuric acid to be pickled, and then washed with pure water. Next, a release layer having a thickness of 50 nm was formed by sputtering titanium on the carrier foil. Thereafter, a metal layer (porosity: 20%) having a thickness of 2 µm was formed by electroless plating at 34°C for 20 minutes with electroless plating solution including 190 to 200 g/L of a metal ion source (CuSO4·5H2O), 0.01 to 0.1 g/L of a nitrogen-containing compound (Guanine), 405 to 420 g/L of a chelating agent (potassium sodium tartrate), a pH adjusting agent (NaOH), and a reducing agent (28% formaldehyde).

### [Comparative Example 1]

A carrier foil made of an 18 µm-thick copper foil was immersed in sulfuric acid to be pickled, and then washed with pure water. Next, a release layer having a thickness of 50 nm was formed by sputtering titanium on the carrier foil. Thereafter, a metal layer having a thickness of 2 µm was formed by electrolytic plating for at 25°C for 10 minutes by applying a current density of 1 ASD with plating solution consisting of 200 g/L of copper sulfate, 100 g/L of sulfuric acid, 50 ppm of chloride ions, 10 ml/L of a carrier, and 0.3 ml/L of a brightener.

### [Experimental Example 1]

The peeling strengths (gf/cm) of the carrier foil-attached metal foil prepared in Example 1 and Comparative Example 1 were measured based on the IPC-TM-650 standard (using a plate-shaped test piece having a width of 10 mm x a length of 10 cm), and the results were shown in Table 1 below.

**[Table 1]**

| | Peeling strength |
|---|---|
| Example 1 | Immeasurable (no peeling) |
| Comparative Example 1 | 50 f/cm |

Referring to Table 1, it could be confirmed that in the carrier foil-attached metal foil of Example 1 according to the present invention, peeling did not occur, whereas the peeling occurred in the carrier foil-attached metal foil of Comparative Example 1.

### [Preparation Example 1 and Comparative Preparation Example 1]

A resin substrate (Doosan Electronics prepreg (DS-7409HG)) was laminated on the carrier foil-attached metal foils prepared in Example 1 and Comparative Example 1, and then pressed at a pressure of 30 MPa for 100 minutes at 210°C to prepare laminates for a printed wiring board, respectively.

### [Experimental Example 2]

The peeling strengths (gf/cm) of the laminates for the printed wiring board prepared in Preparation Examples 1 and 2 and Comparative Preparation Example 1, respectively, were measured based on the IPC-TM-650 standard (using a plate-shaped test piece having a width of 10 mm x a length of 10 cm), and the results were shown in Table 2 below.

**[Table 2]**

| | Peeling strength |
|---|---|
| Preparation Example 1 (Example 1) | 8 gf/cm |
| Comparative Preparation Example 1 (Comparative Example 1) | 45 gf/cm |

Referring to Table 2 above, it could be confirmed that the carrier foil-attached metal foil of Example 1 according to the present invention showed a required level (5 to 10 gf/cm) of the peeling strength after bonding with the resin substrate. This can be seen to support the fact that an oxide release layer is formed between the release layer and the metal layer in the bonding process with the resin substrate to enable peeling.

### [Explanation of Reference Numerals and Symbols]

10: Carrier foil
20: Release layer
30: Metal layer
40: Resin layer
50: Oxide release layer

## Claims

1. A carrier foil-attached metal foil comprising:
a carrier foil;
a release layer provided on the carrier foil and comprising at least one selected from the group consisting of titanium, copper, nickel and aluminum; and
a metal layer provided on the release layer and formed by electroless plating.

2. The carrier foil-attached metal foil of claim 1, wherein the release layer has thickness of 1 nm to 100 nm.

3. The carrier foil-attached metal foil of claim 1, wherein the metal layer is a porous metal layer.

4. The carrier foil-attached metal foil of claim 3, wherein the porosity of the metal layer is 5% to 40%.

5. A laminate for a printed wiring board comprising:
a carrier foil;
a release layer provided on the carrier foil and comprising at least one selected from the group consisting of titanium, copper, nickel and aluminum;
a metal layer provided on the release layer and formed by electroless plating; and
a resin layer provided on the metal layer.

6. The laminate for the printed wiring board of claim 5, wherein the laminate for the printed wiring board further include an oxide release layer provided between the release layer and the metal layer.

7. A manufacturing method of a laminate for a printed wiring board comprising:
preparing a carrier foil;
forming a release layer comprising at least one selected from the group consisting of titanium, copper, nickel and aluminum on the carrier foil;
forming a metal layer on the release layer by electroless plating;
forming a resin layer by laminating a resin substrate on the metal layer, and
pressing the resin layer to bond with the metal layer.

8. The manufacturing method of the laminate for the printed wiring board of claim 7, wherein the pressing further include a step of forming an oxide release layer between the release layer and the metal layer by pressing at 10 MPa to 40 MPa and 180°C to 220°C.

9. A printed circuit board comprising a metal circuit layer in which a circuit wiring is formed on the metal layer of the laminate for the printed wiring board according to any one of claims 5 and 6.
